**Europäisches Patentamt**

**European Patent Office**

**Office européen des brevets**

(19)

(11) Veröffentlichungsnummer: **0 213 424 B1**

(12) **EUROPÄISCHE PATENTSCHRIFT**

(45) Veröffentlichungstag der Patentschrift:
09.05.90

(51) Int. Cl.⁵: **G01R 21/00**

(21) Anmeldenummer: 86110755.5

(22) Anmeldetag: 04.08.86

(54) **Verfahren zum Messen elektrischer Energie.**

(30) Priorität: 09.08.85 DE 3528710

(43) Veröffentlichungstag der Anmeldung:
11.03.87 Patentblatt 87/11

(45) Bekanntmachung des Hinweises auf die Patenterteilung:
09.05.90 Patentblatt 90/19

(84) Benannte Vertragsstaaten:
AT CH DE FR GB IT LI

(56) Entgegenhaltungen:
FR-A- 2 357 907

IEEE TRANSACTIONS ON POWER APPARATUS AND SYSTEMS, Band PAS-103, Nr. 10, Oktober 1984, Seiten 2919-2925, New York, US; G.N. STENBAKKEN et al.: "A wideband sampling wattmeter"
IEEE TRANSACTIONS ON INDUSTRIAL ELECTRONICS AND CONTROL INSTRUMENTATION, Band IECI-28, Nr. 3, August 1981, Seiten 180-184, IEEE, New York, US; J.J. HILL et al.: "Design of a microprocessor-based digital wattmeter"

(73) Patentinhaber: Hallwirth, Volker, Dipl.-Ing.,
Haldenweg 22, D-7742 St. Georgen(DE)

(72) Erfinder: Hallwirth, Volker, Dipl.-Ing., Haldenweg 22,
D-7742 St. Georgen(DE)

## Beschreibung

Die Erfindung betrifft ein Verfahren zum Messen der von einem Wechselstromverbraucher aufgenommenen elektrischen Energie gemäß dem Oberbegriff des Anspruchs 1.

Aus der DE-A 2 630 959 ist es bekannt, Strom und Spannung mehrmals während einer Wechselstromperiode abzutasten, in zwei Digitalwerte umzusetzen und diese miteinander zu multiplizieren. Die so ermittelten Augenblicksleistungen werden addiert, um ein Maß für die verbrauchte Energie zu erhalten. Das bekannte Verfahren hat den Nachteil, daß die Abtast- und Rechenvorgänge sehr rasch ablaufen müssen und ein leistungsfähiger Rechner verwendet werden muß. Dieses Problem wurde mit Hilfe von Inter- und Extrapolationsverfahren zu lösen versucht.

Ferner ist aus der Veröffentlichung IEEE TRANSACTIONS ON POWER APPARATUS AND SYSTEMS, Band PAS-103, Nr. 10, Oktober 1984, Seiten 2919–2925, New York, US; G.N. Stenbakken et al.: "A wideband sampling wattmeter" bekannt, daß in einem Summationsintervall n mal Strom und Spannung in äquidistanten Zeitabständen $\Delta t$ abgetastet werden, wobei sich das Summationsintervall um weniger als $\Delta t$ von einem ganzzahligen Vielfachen der Periodendauer der zu messenden Spannung unterscheidet. Die Strom- und Spannungswerte werden in einem außerhalb des Mikrocomputers befindlichen Multiplizier-Akkumulator miteinander multipliziert und die Ergebnisse in den Mikrocomputer gelesen, welcher daraus die Leistung berechnet und zur Anzeige bringt. Der Nachteil dieser Lösung ist, daß zur Leistungsmessung hochfrequenter Signale das Verfahren und die Einrichtungen auf möglichst hohe und konstante Abtastrate ausgelegt sind und somit für kostengünstige Lösungen im Bereich der Netzfrequenz nicht zum Tragen kommen.

Des weiteren ist aus der Veröffentlichung IEEE TRANSACTIONS ON INDUSTRIAL ELECTRONICS AND CONTROL INSTRUMENTATION, Band IECI-28, Nr. 3, August 1981, Seiten 180–184, IEEE, New York, US; J.J. Hill et al.: "Design of a microprocessor-based digital wattmeter" bekannt, daß n mal Strom und Spannung über m Perioden des zu messenden Signals abgetastet wird, die abgetasteten Strom- und Spannungswerte in einem Analogmultiplexer multipliziert werden und dann das Ergebnis der Multiplikation nach seiner Wandlung in einen Digitalwert von einem Mikrocomputer eingelesen wird, um mit anderen so erhaltenen Meßwerten innerhalb eines Meßzyklusses die verbrauchte Leistung zu berechnen und zur Anzeige zu bringen. Der Nachteil dieses Verfahrens liegt in dem erforderlichen Analogmultiplizierer, der deswegen eingesetzt wird, damit die Zykluszeit der Dateneingaberoutine des Mikroprozessors so klein gehalten werden kann, daß eine Anzahl n von Abtastungen größer 30 innerhalb eines Meßzyklusses erreicht werden kann.

Der vorliegenden Erfindung liegt die Aufgabe zugrunde, ein Verfahren der eingangs genannten Art zu schaffen, bei dem Strom und Spannung mit im Vergleich zu den bekannten Verfahren niedriger Frequenz abgetastet werden.

Diese Aufgabe wird erfindungsgemäß mit den im kennzeichnenden Teil des Anspruchs 1 angegebenen Maßnahmen gelöst.

In jedem Abtastintervall kann mehrmals abgetastet werden, wobei die einzelnen Abtastungen innerhalb der Intervalle jeweils dieselbe zeitliche Lage haben, z.B. jeweils eine Abtastung am Anfang des Intervalls und eine in der Intervallmitte. Im allgemeinen wird man nur einmal je Intervall abtasten, damit die Abtastfrequenz möglichst niedrig ist. Aus demselben Grund sind vorteilhaft die Abtastintervalle größer als die Periodendauer. Die Dauer des Abtastintervalls kann auch ein Mehrfaches der Periodendauer betragen. Voraussetzung ist lediglich ein periodischer Wechselstrom, Kurvenform und Wechselstromfrequenz haben auf die Genauigkeit des neuen Verfahrens praktisch keinen Einfluß. Ferner eignet sich das neue Verfahren auch zur Energiemessung bei Gleichströmen, denen periodische Wechselströme überlagert sind.

Anhand der Zeichnung wird im folgenden ein Ausführungsbeispiel der Erfindung näher beschrieben und erläutert.

In Figur 1 ist die Funktion des Ausführungsbeispiels verdeutlicht;

Figur 2 zeigt das Prinzipschaltbild einer Anordnung zur Durchführung des neuen Verfahrens.

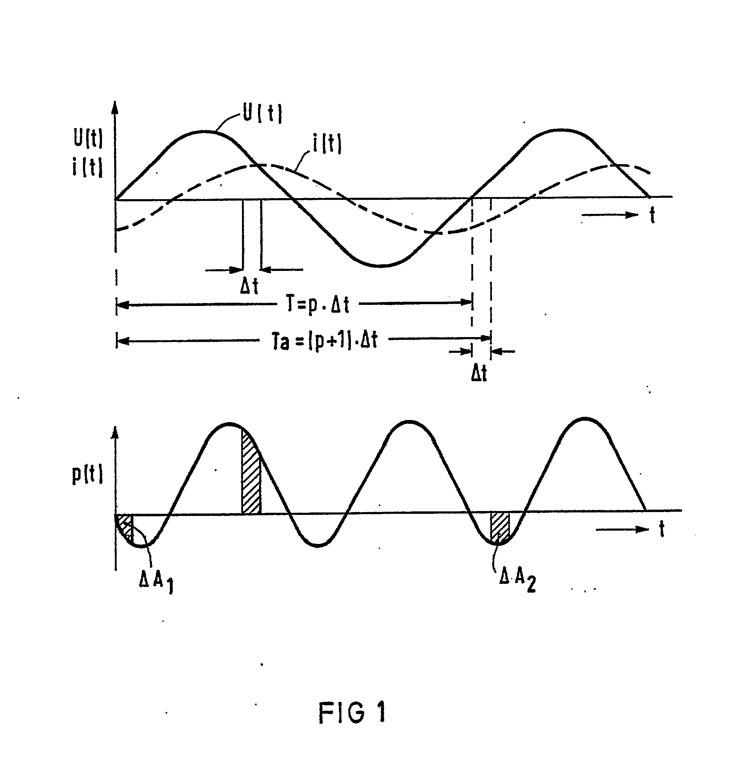

Im oberen Diagramm der Figur 1 ist der zeitliche Verlauf einer Wechselspannung U(t), die an einem Verbraucher liegt, und des zugehörigen Stromes i(t) dargestellt. Die Periodendauer ist T. Ein Abtastintervall Ta ist um die Zeitdauer $\Delta t$ größer als die Periodendauer T. Der zeitliche Verlauf der elektrischen Leistung ist im unteren Diagramm veranschaulicht. Spannung und Strom sollen jeweils zu Beginn eines Abtastintervalles gemessen werden. Daraus wird die Augenblicksleistung bzw. die verbrauchte Energie in der Zeit $\Delta t$ berechnet. Diese Augenblicksleistungen werden über je einen Meßzyklus von p Abtastintervallen summiert und das Ergebnis mit p+1 multipliziert, wobei p gleich dem Verhältnis von Periodendauer T zum Betrag $\Delta t$ ist. Das Ergebnis ist die im Meßzyklus verbrauchte Energie. Die fortlaufende Addition der einzelnen Ergebnisse in den Meßzyklen ergibt den Gesamt-Energieverbrauch. Sind die Abtastintervalle nicht um den Betrag $\Delta t$ größer als die Wechselstromperiode, sondern kleiner, wird die Summe der momentanen Einzelleistungen anstatt mit dem Faktor p+1 mit dem Faktor p-1 multipliziert. Werden je Abtastintervall mehrere Abtastungen vorgenommen, so ist die Summe der momentanen Leistungen noch durch die Zahl der Abtastungen je Abtastintervall zu dividieren.

Bei dem beschriebenen Verfahren ist die Abtastfrequenz sehr niedrig; sie ist etwa gleich der Netzfrequenz. Dementsprechend steht für jede Rechenoperation so viel Zeit zur Verfügung, daß sie von einem einfachen handelsüblichen Mikroprozessor ausgeführt werden kann, so daß das Verfahren mit einer sehr kostengünstigen Anordnung ausgeführt werden kann.

Eine weitere Herabsetzung der Abtastfrequenz kann dadurch erreicht werden, daß die Dauer des Abtastintervalls Ta = n . T + Δt, also etwa gleich einem ganzzahligen Vielfachen n der Periodendauer gewählt wird.

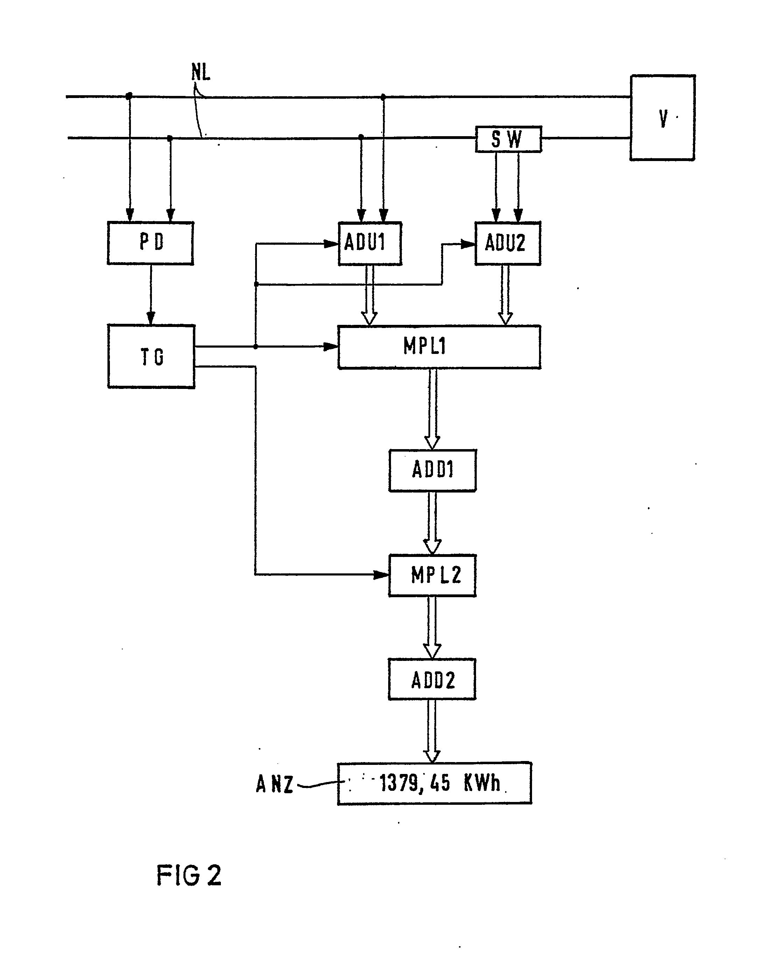

In Figur 2 ist mit NL eine Netzleitung bezeichnet, an die ein Verbraucher V angeschlossen ist, dessen Energieverbrauch gemessen werden soll. Die Spannung auf der Leitung NL ist einer Einheit PD zugeführt, welche die Periodendauer der Netzfrequenz bestimmt und ein entsprechendes Signal einem Taktgeber TG zuführt. Dieser bildet daraus die Abtastintervalle. Ein erster Analog-Digital-Umsetzer ADU1 setzt die Spannung auf der Netzleitung NL in einen ersten Digitalwert um. Ein zweiter Analog-Digital-Umsetzer ADU2, der an einen Stromwandler SW angeschlossen ist, liefert einen dem Strom entsprechenden Digitalwert. Die Umsetzzeitpunkte werden vom Taktgeber TG bestimmt. Ein erster Multiplizierer MPL1 multipliziert die beiden Digitalwerte. Die Ergebnisse, die den momentanen Leistungen entsprechen, werden in einem ersten Addierer ADD1 aufsummiert. Nach Ablauf je eines oder mehrerer Meßzyklen wird die Summe in einem Multiplizierer MPL2 mit dem Wert p+1 multipliziert und das Produkt einem Addierer ADD2 zugeführt. Eine an diesen angeschlossene Anzeigeeinheit ANZ gibt den Gesamt-Energieverbrauch an.

## Patentansprüche

1. Verfahren zum Messen der von einem Wechselstromverbraucher aufgenommenen elektrischen Energie, bei dem
- zyklisch in Abtastintervallen (Ta) Spannung und Strom abgetastet, miteinander multipliziert und die Ergebnisse addiert werden,
- die Dauer der Abtastintervalle (Ta) so gewählt wird, daß sie von einem ganzzahligen Vielfachen der Periodendauer (T) des Wechselstromes um eine Zeitdifferenz (Δt) abweicht und
- in jedem Abtastintervall (Ta) mindestens einmal Strom und Spannung abgetastet und miteinander multipliziert werden, dadurch gekennzeichnet, daß mehrere Abtastintervalle (Ta) zu einem Meßzyklus zusammengefaßt werden, wobei die Anzahl (p) der Abtastintervalle (Ta) je Meßzyklus gleich dem Verhältnis der Periodendauer (T) des Wechselstroms zur Zeitdifferenz (Δt) ist,
- daß die innerhalb des Meßzyklus vorhandenen Produkte von Strom und Spannung addiert und im Falle, daß die Abtastintervalle (Ta) größer als die Periodendauer (T) sind, mit dem Faktor (p+1) und im Falle, daß die Abtastintervalle (Ta) kleiner als die Periodendauer (T) sind, mit dem Faktor (p−1) multipliziert und durch die Anzahl der Abtastungen je Abtastintervall (Ta) dividiert werden.
2. Verfahren nach Anspruch 1, dadurch gekennzeichnet, daß die Abtastintervalle (Ta) größer als die Periodendauer (T) sind.

## Claims

1. Method for measuring the electrical energy consumed by an alternating current consumer, whereby,

- the voltage and current are sampled cyclically in sampling intervals (Ta), multiplied with each other and the results added,
- the length of the sampling intervals (Ta) is selected so that they differ from a whole multiple of the period (T) of the alternating current by a time difference (Δt) and
- in each sampling interval (Ta) current and voltage are sampled and multiplied together at least once, characterised by
- several sampling intervals (Ta) forming one measurement cycle, whereby the number (p) of sampling intervals (Ta) per measurement cycle equals the ratio of the period (T) of the alternating current to the difference (Δt),
- the products of current and voltage being added within the measurement cycles and if the sampling intervals (Ta) are greater than the period (T) being multiplied by the factor (p+1) and if the sampling intervals (Ta) are less than the period (T) by the factor (p−1) and being divided by the number of samples per sampling interval (Ta).
2. Method according to claim 1, characterised by, the sampling intervals (Ta) being greater than the period (T).

## Revendications

1. Procédé pour mesurer l'énergie l'électrique consommée par une charge alimentée en courant alternatif, selon lequel:
- la tension et le courant sont échantillonés périodiquement à des intervalles d'échantillonnage (Ta), multipliés l'un par l'autre et les résultats obtenus sont additionnés,
- la durée de chaque intervalle d'échantillonnage (Ta) est choisie de façon qu'elle ne diffère que d'un intervalle de temps (Δt) d'un multiple entier de la durée de la période (T) du courant alternatif et
- que dans chaque intervalle d'échantillonnage (Ta) le courant et la tension sont échantillonés au moins une fois et multipliés l'un par l'autre caractérisé par le fait
- que plusieurs intervalles d'échantillonnage (Ta) puissent être regroupés en un cycle de mesure, étant donné que le nombre (p) des intervalles d'échantillonnage (Ta) par cycle de mesure est égal au rapport durée de la période (T) du courant alternatif divisé par la différence de temps (Δt)
- que les produits courant/tension obtenus pendant un cycle de mesure sont multipliés par le facteur (p+1) dans le cas où les intervalles d'échantillonnage (Ta) sont supérieurs à la durée de la période et par le facteur (p−1) si les intervalles d'échantillonnage (Ta) sont inférieurs à la durée de la période et sont divisés par le nombre d'échantillons pris dans un intervalle d'échantillonnage.
2. Procédé d'après la revendication 1, caractérisé par le fait que les intervalles d'échantillonnage (Ta) sont supérieurs à la durée de la période (T).

FIG 1

NL

V

S W

P D

ADU1

ADU2

T G

MPL1

ADD1

MPL2

ADD2

ANZ ─── ∴∴ 1379,45 KWh

FIG 2